# EUROPÄISCHE PATENTSCHRIFT

(11) **EP 2 087 590 B1**
(45) Veröffentlichungstag und Bekanntmachung des Hinweises auf die Patenterteilung: **17.02.2010**
(21) Anmeldenummer: 06819364.8
(22) Anmeldetag: 09.11.2006
(51) Int. Cl.: H03K 3/57

(54) **SCHALTUNGSANORDNUNG**
CIRCUIT ARRANGEMENT
MONTAGE ÉLECTRIQUE

(43) Veröffentlichungstag der Anmeldung: 12.08.2009
(73) Patentinhaber: Osram Gesellschaft mit beschränkter Haftung, 81543 München (DE)
(72) Erfinder: DELLIAN, Harald, 83533 Edling (DE); SCHALLMOSER, Oskar, 85521 Ottobrunn (DE)
(86) Internationale Anmeldenummer: PCT/EP2006/068287
(87) Internationale Veröffentlichungsnummer: WO 2008/055546

(56) Entgegenhaltungen:
- EP-A- 1 128 557
- EP-A- 1 643 816

## Beschreibung

### Technisches Gebiet

Die Erfindung betrifft eine Schaltungsanordnung mit einem ersten und einem zweiten Eingangsanschluss zum Anschließen einer Eingangsspannung, einem ersten und einem zweiten Ausgangsanschluss zum Bereitstellen einer AusgangsSpannung, einer Anzahl n an Transformatoren, die jeweils eine Primärseite und eine Sekundärseite aufweisen, wobei n eine gerade Zahl ist, wobei die Sekundärseiten der n Transformatoren in Reihe zwischen den ersten und den zweiten Ausgangsanschluss gekoppelt sind, wobei die Transformatoren, i=1 bis n, ausgehend vom ersten Ausgangsanschluss zum zweiten Ausgangsanschluss beginnend mit 1 fortlaufend bis n durchnummeriert sind, wobei jede Primärseite einen ersten und einen zweiten Anschluss aufweist, wobei der jeweils erste Anschluss mit jeweils einem ersten Potential gekoppelt ist und der jeweils zweite Anschluss über einen elektronischen Schalter mit jeweils einem zweiten Potential koppelbar ist, wobei im Betrieb der Schaltungsanordnung das erste Potential größer ist als das zweite Potential, und wobei das erste und das jeweils zweite Potential aus der Eingangsspannung abgeleitet sind, wobei jeweils mindestens zwei zweite Anschlüsse zur Bildung einer Kombination derart miteinander gekoppelt sind, dass sie durch denselben elektronischen Schalter mit einem jeweils gemeinsamen zweiten Potential koppelbar sind.

### Stand der Technik

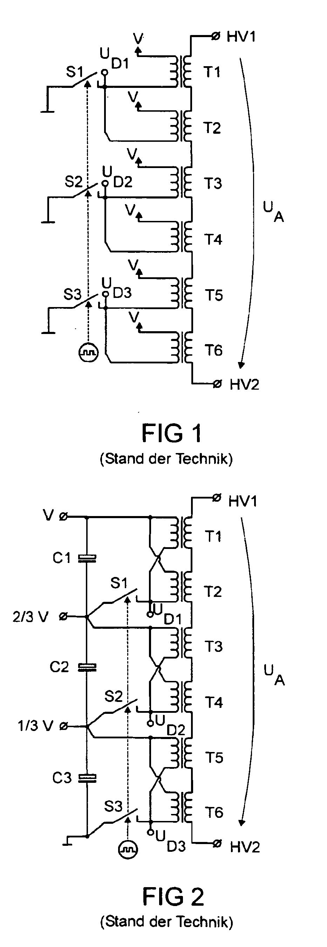

Derartige, aus dem Stand der Technik bekannte Schaltungsanordnungen sind in Fig. 1 und Fig. 2 dargestellt, die zur Darlegung der der Erfindung zugrunde liegenden Problematik herangezogen werden sollen. Die der Erfindung zugrunde liegenden Problematik soll der Einfachheit halber insbesondere am Beispiel von Klasse E-Konvertern als Ausgangsstufe zum Betreiben von elektrischen Lampen beschrieben werden, wobei als elektronische Schalter MOSFET-Transistoren verwendet werden. Wie für den Fachmann ohne weiteres erkennbar sein wird, sind erfindungsgemäße Schaltungsanordnungen jedoch auch auf vielen anderen Gebieten einsetzbar.

Fig. 1 zeigt beispielhaft eine gattungsgemäße Schaltungsanordnung, bei der die elektronischen Schalter S1, S2, S3 parallel angeordnet sind, d. h. jeder Schalter S1, S2, S3 ist einerseits über eine Primärwicklung eines zugeordneten Transformators mit der Zwischenkreisspannung V, andererseits mit dem Bezugspotential, vorliegend Masse, verbunden. Vorliegend sind jeweils zwei Transformatoren primärseitig parallel geschaltet und werden von einem elektronischen Schalter bedient, so die Transformatoren T1, T2 vom elektronischen Schalter S1, die Transformatoren T3 und T4 vom elektronischen Schalter S2 und die Transformatoren T5 und T6 vom elektronischen Schalter S3. Bei Realisierung der elektronischen Schalter S1 bis S3 durch jeweils einen MOSFET-Transistor, ist die Source mit dem Bezugspotential, vorliegend Masse, verbunden, während das Drain mit der Primärseite des jeweiligen Transformators verbunden ist. Die Potentiale an den Drains der Schalter S1 bis S3 sind bezeichnet mit U_{D1}, U_{D2}, U_{D3}. Die Sekundärseiten der Transformatoren T1 bis T6 sind zueinander in Serie geschaltet und stellen die Ausgangsspannung U_{A} zwischen den Ausgangsanschlüssen HV1, HV2 bereit.

Die mit Bezug auf Fig. 1 eingeführten Bezugszeichen gelten für gleiche und ähnliche Bauelemente und Größen in den weiteren Figuren, und werden deshalb nicht nochmals eingeführt. Die Schalter S1 bis S3 werden, wie für den Fachmann bekannt, mit einer Frequenz f geöffnet und geschlossen.

So zeigt Fig. 2 eine aus dem Stand der Technik bekannte Schaltungsanordnung, bei der die Primärseiten der Transformatoren T1 bis T6 in Reihe zueinander angeordnet sind, wobei wiederum jeder Schalter S1 bis S3 zwei Transformatoren bedient.

In der Praxis wurde festgestellt, dass das Potential U_{D1} bis U_{D3} an den Schaltern S1 bis S3 deutliche Schwankungen aufweist, wobei die Unterschiede zwischen den Potentialen U_{D1} bis U_{D3} so groß sein können, dass diese für den Betrieb problematisch werden.

Für die aus dem Stand der Technik bekannte Schaltungsanordnungen wurden mit dem Ziele der Gleichverteilung der Spannungen an den Schaltern, d. h. der Symmetrierung der Potentiale U_{D1} bis U_{D3}, Symmetrierkondensatoren eingefügt. Die Symmetrierkondensatoren (nicht dargestellt) wurden dabei zwischen den Potentialen U_{D1} und U_{D2}, den Potentialen U_{D2} und U_{D3}, sowie den Potentialen U_{D3} und U_{D1} angeordnet.

Ohne die Maßnahme der Symmetrierkondensatoren mussten die Schalter recht groß dimensioniert werden, um für das maximale Potential U_{D1} bis U_{D3} ausgelegt zu sein. Eine zu kleine Dimensionierung führte zur Zerstörung der elektronischen Schalter S1 bis S3.

### Darstellung der Erfindung

Die Aufgabe der vorliegenden Erfindung besteht deshalb darin, eine gattungsgemäße Schaltungsanordnung derart weiterzubilden, dass eine kleinere Dimensionierung der elektronischen Schalter S1 bis S3 ermöglicht wird, bei gleichzeitiger Bereitstellung einer vergleichbaren Zuverlässigkeit.

Diese Aufgabe wird gelöst durch eine Schaltungsanordnung mit den Merkmalen von Patentanspruch 1.

Der vorliegenden Erfindung liegt die Erkenntnis zugrunde, dass für die Variationen der Potentiale U_{D1} bis U_{D3} die internen Schwingkreise in den Transformatoren T1 bis T6 verantwortlich sind. Interne Schwingkreise werden nämlich gebildet durch die internen parasitären Kapazitäten zusammen mit den Streuinduktivitäten der Transformatoren T1 bis T6. Die internen Kapazitäten können, sofern an den Ausgangsanschlüssen HV1, HV2 eine Lampe angeschlossen wird, in der Größenordnung von etwa 10 % der Lampenkapazität liegen. Die Streuinduktivität kann bei etwa 2 % der Hauptinduktivitäten der Transformatoren T1 bis T6 liegen.

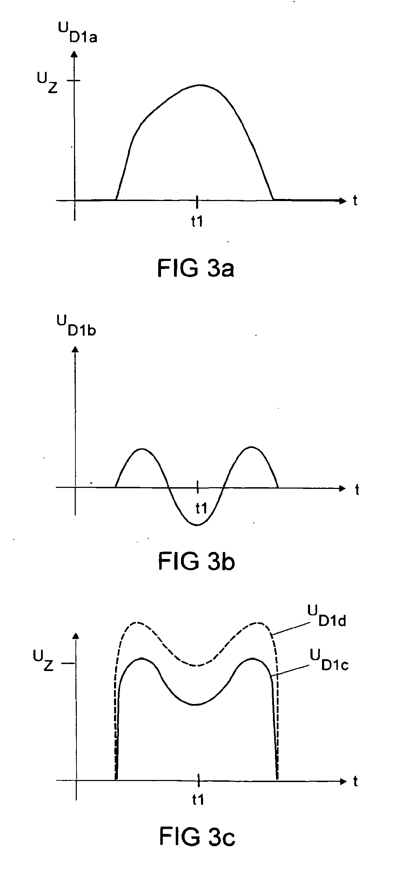

Da die Ausgangsspannung U_{A} symmetrisch um das Bezugspotential bereitgestellt wird, koppeln die jeweiligen Sekundärseiten der Transformatoren T1 bis T6 in Abhängigkeit ihrer Position in der Serienschaltung der Transformatoren T1 bis T6 unterschiedliche Signale auf ihre jeweilige Primärseite zurück. Insbesondere koppeln die "oberhalb der Mitte" angeordneten Transformatoren T1 bis T3 ein positives Signal zurück, während die "unterhalb der Mitte" angeordneten Transformatoren T4 bis T6 ein negatives Signal zurückkoppeln. Dadurch wird insbesondere bei Anwendungen im Lampenbereich, die Zündung der Lampe gestört. Für die Zündung einer Lampe ist beispielsweise eine Zündspannung nötig, die auf der Primärseite die Amplitude U_{z} aufweist und deren zeitlicher Verlauf am Beispiel des Potentials U_{D1} in Fig. 3a als U_{D1a} dargestellt ist. Insbesondere dargestellt ist der erwünschte ideale Verlauf, der ein einzelnes Maximum bei U_{z} aufweist. In der Praxis ist es jedoch so, dass dieser Impuls überlagert wird durch parasitäre Schwingungen. Beispielhaft ist der Einfachheit halber in Fig. 3b der zeitliche Verlauf einer einzelnen parasitären Schwingung U_{D1b} dargestellt. Der sich durch Addition der Signale U_{D1a} und U_{D1b} ergebende Lauf ist in Fig. 3c dargestellt und mit U_{D1c} bezeichnet. Weiterhin ist zu berücksichtigen, dass Maxima der einzelnen Potentiale U_{D1} bis U_{D3} nicht auf einen Zeitpunkt fallen, was unter anderem auch an den Unterschieden in den parasitären Bauelementen liegt. Daher findet keine optimale Energieausnutzung der Zünderenergie statt, wodurch sich ein schlechter Wirkungsgrad ergibt. Wie leicht zu erkennen ist, ergeben sich bereits bei einem Potential zwei Maxima, wobei keines auf den Zeitpunkt t1 fällt, für den die Zündung ausgelöst wird. Da zum Zeitpunkt t1 der zeitliche Verlauf der Spannung U_{D1c} überdies die Amplitude U_{z} nicht erreicht, muss die Spannung durch andere Dimensionierung angehoben werden, so dass sich der zeitliche Verlauf U_{D1d} ergibt. Wie leicht zu erkennen, weist dieser Kurvenzug zwei Maxima auf, die größer sind als das lokale Minimum zum Zeitpunkt t1. Dadurch werden die elektronischen Schalter über Gebühr belastet und müssen größer dimensioniert werden. Dies resultiert überdies darin, dass einzelne Transformatoren mit höheren Strömen belastet werden, je nach ihrer Position in der Serienschaltung T1 bis T6, und daher ebenfalls zur Verhinderung von Ausfällen größer dimensioniert werden müssen. Es resultiert weiterhin in einer Störung der Zündung der Lampe infolge der zwei auftretenden Maxima.

Auf dieser Basiserkenntnis aufbauend liegt der vorliegenden Erfindung die Idee zugrunde, dass eine Symmetrierung der Potentiale U_{D1} bis U_{D3} erreicht werden kann, wenn diese internen, störenden Ströme aufgehoben werden entweder dadurch dass die Ströme zumindest teilweise kompensiert werden oder dass ein geschlossener Kreislauf entsteht. Für eine Verbesserung ist es bereits ausreichend, wenn ein elektronischer Schalter S1, S2, S3 jedenfalls nicht durchgehend mit zwei aufeinander folgenden der Transformatoren T1 bis T6 gekoppelt ist. Im Stand der Technik, vergleiche Fig. 1 und Fig. 2, waren jedenfalls immer die beiden oberen T1, T2, die beiden mittleren T3, T4 und die beiden unteren Transformatoren T5, T6 miteinander gekoppelt, was letztendlich hinsichtlich der Kompensation der internen Ströme den Worst Case darstellte. Durch erfindungsgemäße Schaltungsanordnungen konnte eine bis zu 30 % geringere Belastung der elektronischen Schalter S1 bis S3 gemessen werden. Überdies können nunmehr die Symmetrierkondensatoren entfallen.

Wie für den Fachmann offensichtlich, kann die erfindungsgemäße Idee selbstverständlich auf Schaltungsanordnungen mit einer anderen Anzahl von Transformatoren, mit einer anderen Anzahl von Schaltern und einer anderen Anzahl von Transformatoren, die pro Schalter bedient werden, realisiert werden.

Wie bereits erwähnt, können alle Primärseiten mit Bezug auf die Eingangsspannung parallel geschaltet sein. Dabei kann bei allen Kombinationen a ungleich 1 sein, insbesondere a=konst. Bei a=konst, ergeben sich regelmäßige Abstände, d. h. im Ausführungsbeispiel sind die Primärseiten des Transformators T1 und des Transformators T4, des Transformators T2 und des Transformators T5 sowie des Transformators T3 und des Transformators T6 miteinander verbunden. Alternativ können jeweils zwei zweite Anschlüsse zur Bildung einer Kombination gekoppelt sein, wobei die jeweilige Kombination die zweiten Anschlüsse der Transformatoren i und (n-i+1) enthält, wobei i=1 bis n/2. Dadurch ergibt sich eine symmetrische Kopplung der Primärseiten. Im Ausführungsbeispiel sind daher die Transformatoren T1, T6, die Transformatoren T2, T5 sowie die Transformatoren T3, T4 miteinander verbunden.

Die Primärseiten können jedoch auch in Reihe geschaltet sein, wobei sich die beiden jeweils ersten Potentiale einer Kombination j von Transformatoren ergeben zu (b-j+1)/b*V, wobei b die Anzahl von Kombinationen darstellt und j gleich 1 bis b. Dabei ergeben sich die jeweils zweiten Potentiale einer Kombination j von Transformatoren zu (b-j)/d*V, wobei wiederum b die Anzahl von Kombinationen darstellt und j gleich 1 bis b.

Dabei können die Kombinationen j in beliebiger Reihenfolge nummeriert sein, d. h. der Schalter S1 kann beispielsweise mit den Transformatoren T1 und T4, der Schalter S2 mit den Transformatoren T3 und T6 und der Schalter S3 mit den Transformatoren T5 und T2 ("einfach verzopft") verbunden sein bzw. der Schalter S1 kann mit den Transformatoren T1 und T4, der Schalter S2 mit den Transformatoren T2 und T5 und der Schalter S3 mit den Transformatoren T3 und T6 ("doppelt verzopft") verbunden sein.

Bei der Reihenschaltung der Primärseiten kann ein regelmäßiger Abstand vorgesehen sein, d. h. dass bei allen Kombinationen a ungleich 1 ist, insbesondere a=konst. Bei a=konst. sind im Ausführungsbeispiel die Transformatoren T1 und T4, die Transformatoren T2 und T5 sowie die Transformatoren T3 und T6 miteinander gekoppelt. Werden jeweils zwei zweite Anschlüsse zur Bildung einer Kombination gekoppelt, wobei die jeweilige Kombination die zweiten Anschlüsse der Transformatoren i und (n-i+1) enthält, wobei i=1 bis n/2, ergibt sich eine symmetrische Kopplung. Im Ausführungsbeispiel wären dann die Transformatoren T1 und T6, die Transformatoren T2 und T5 sowie die Transformatoren T3 und T4 miteinander gekoppelt.

Bevorzugt ist hier der elektronische Schalter als MOSFET-Transistor realisiert.

Weitere bevorzugte Ausführungsbeispiele ergeben sich aus den Unteransprüchen.

### Kurze Beschreibung der Zeichnung(en)

Im Nachfolgenden werden nunmehr Ausführungsbeispiele der Erfindung unter Bezugnahme auf die beigefügten Zeichnungen näher beschrieben. Es zeigen:
- Fig. 1: in schematischer Darstellung eine aus dem Stand der Technik bekannte Schaltungsanordnung, bei der die Primärseiten parallel geschaltet sind;
- Fig. 2: eine aus dem Stand der Technik bekannte Schal- tungsanordnung, bei der die Primärseiten in Reihe geschaltet sind;
- Fig. 3: in schematischer Darstellung der zeitliche Verlauf des Potentials U_{D1} gemäß Fig. 1a aufgeteilt in i- dealer Verlauf U_{D1a}, Verlauf der Störung U_{D1b}, rea- ler Verlauf U_{D1c}, sowie modifizierter realer Ver- lauf U_{D1d};
- Fig. 4: in schematischer Darstellung ein Ausführungsbei- spiel einer erfindungsgemäßen Schaltungsanordnung bei paralleler Verschaltung der Primärseiten und "einfacher Verzopfung";
- Fig. 5: in schematischer Darstellung ein Ausführungsbei- spiel einer erfindungsgemäßen Schaltungsanordnung bei paralleler Verschaltung der Primärseiten und "doppelter Verzopfung";
- Fig. 6: in schematischer Darstellung ein Ausführungsbei- spiel einer erfindungsgemäßen Schaltungsanordnung bei Reihenschaltung der Primärseiten und "einfa- cher Verzopfung";
- Fig. 7: in schematischer Darstellung ein Ausführungsbei- spiel einer erfindungsgemäßen Schaltungsanordnung bei Reihenschaltung der Primärseiten und "doppel- ter Verzopfung";
- Fig. 8: in schematischer Darstellung ein Ausführungsbei- spiel einer erfindungsgemäßen Schaltungsanordnung bei paralleler Verschaltung der Primärseiten und "symmetrierter Kopplung"; und
- Fig. 9: in schematischer Darstellung ein Ausführungsbei- spiel einer erfindungsgemäßen Schaltungsanordnung bei Reihenschaltung der Primärseiten und "sym- metrierter Kopplung".

### Bevorzugte Ausführung der Erfindung

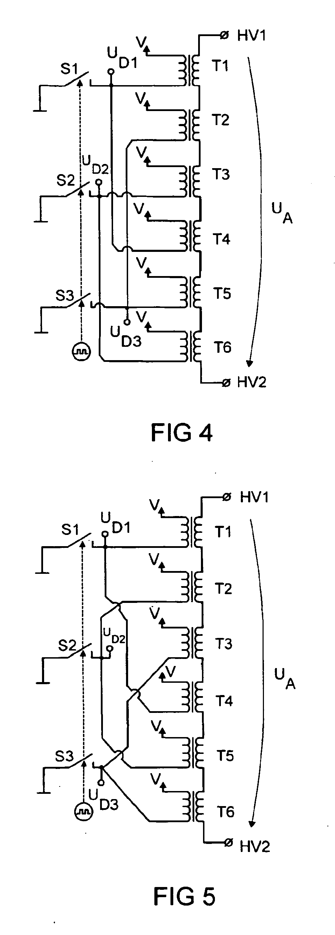

Fig. 4 zeigt in schematischer Darstellung ein erstes Ausführungsbeispiel einer erfindungsgemäßen Schaltungsanordnung, wobei die Primärseiten der Transformatoren T1 bis T6 zueinander parallel geschaltet sind. Im Vergleich zu Fig. 1, siehe insbesondere die Schalter, die mit den jeweiligen Transformatoren verbunden sind, wird diese Anordnung als "einfach verzopft" bezeichnet. Fig. 5 zeigt eine "doppelt verzopfte" Weiterbildung. Ein Vergleich mit Fig. 4 zeigt, dass in Fig. 4 der Schalter S1 die Transformatoren T1 und T4, der Schalter S2 die Transformatoren T3 und T6 und der Schalter S3 die Transformatoren T2 und T5 bedient, während in Fig. 5 der Schalter S1 die Transformatoren T1 und T4, der Schalter S2 die Transformatoren T2 und T5 und der Schalter S3 die Transformatoren T3 und T6 bedient. Der Parameter a ist demnach gleich 3. Wenngleich bei den in den Fig. 4 und 5 gezeigten Ausführungsbeispielen mit 2 Transformatoren pro Schalter die Unterscheidung in "einfach verzopft" und "doppelt verzopft" zu keinen unterschiedlichen Schaltungsstrukturen führt, so gilt dies nicht für Ausführungsbeispiele mit 3 und mehr Transformatoren. Vorliegend wurde eine Variante mit 2 Transformatoren pro Schalter lediglich deshalb gewählt, um das Verständnis des Algorithmus zur Bildung einer "doppelt verzopften" Variante zu erleichtern.

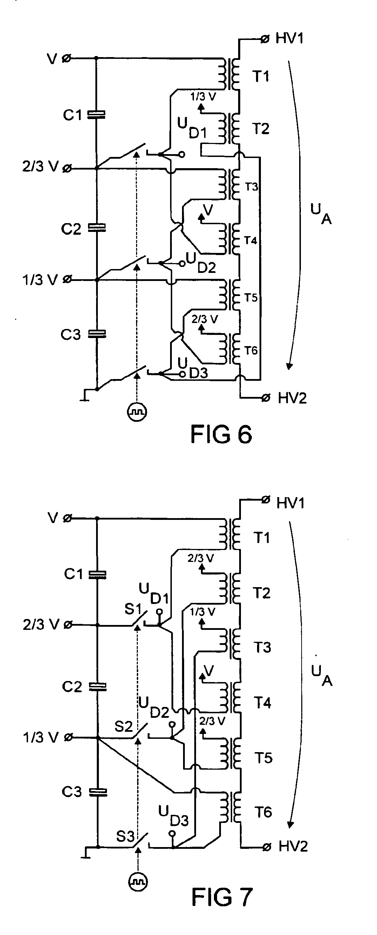

Fig. 6 zeigt ein weiteres Ausführungsbeispiel der erfindungsgemäßen Schaltungsanordnung, bei der die Primärseiten in Reihe geschaltet sind, und zwar in "einfach verzopfter" Anordnung. Fig. 7 zeigt eine Weiterbildung des Ausführungsbeispiels von Fig. 6 in "doppelt verzopfter" Form. Während in der Ausführungsform gemäß Fig. 6 der Schalter S1 mit den Transformatoren T1 und T4, der Schalter S2 mit den Transformatoren T3 und T6 und der Schalter S3 mit den Transformatoren T5 und T2 gekoppelt ist, ist bei der Ausführungsform von Fig. 7 der Schalter S1 mit den Transformatoren T1 und T4, der Schalter S2 mit den Transformatoren T2 und T5 und der Schalter S3 mit den Transformatoren T3 und T6 gekoppelt.

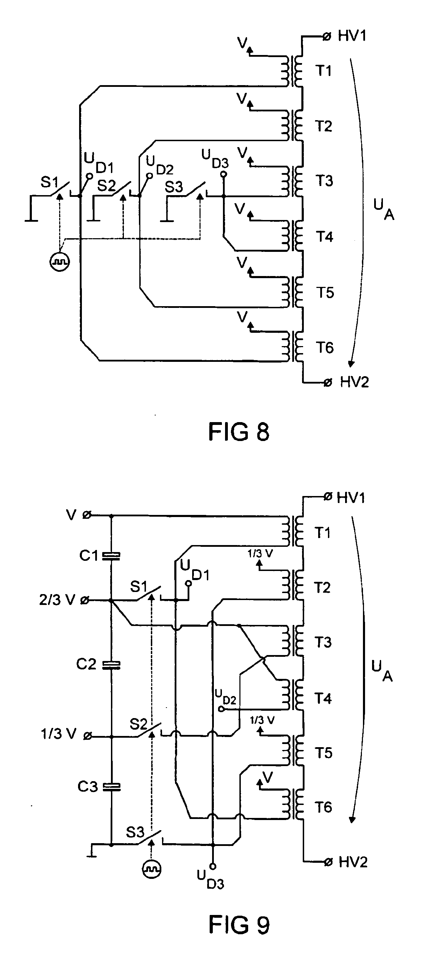

Fig. 8 zeigt eine schematische Darstellung eines Ausführungsbeispiels einer erfindungsgemäßen Schaltungsanordnung, bei der die Primärschaltstufen parallel geschaltet sind, wobei die Kopplung der Transformatoren mit den Schaltern symmetriert ist. So ist vorliegend der Schalter S1 mit den Transformatoren T1 und T6, der Schalter S2 mit den Transformatoren T2 und T5 und der Schalter S3 mit den Transformatoren T3 und T4 gekoppelt.

Fig. 9 zeigt in schematischer Darstellung ein Ausführungsbeispiel mit symmetrierter Kopplung der Transistoren T1 bis T6 bei Reihenschaltung der Primärseiten der Transformatoren. So ist in Fig. 9 der Schalter S1 mit den Transformatoren T1 und T6, der Schalter S2 mit den Transformatoren T3 und T4 und der Schalter S3 mit den Transformatoren T2 und T5 gekoppelt.

Wie für den Fachmann offensichtlich, ergeben sich bei einer anderen Anzahl von Transformatoren weitere Verschaltungsmöglichkeiten, insbesondere Verzopfungsmöglichkeiten.

## Patentansprüche

1. Schaltungsanordnung mit
- einem ersten und einem zweiten Eingangsanschluss zum Anschließen einer Eingangsspannung (V);
- einem ersten und einem zweiten Ausgangsanschluss (HV1, HV2) zum Bereitstellen einer Ausgangsspannung (U_{A});
- einer Anzahl n an Transformatoren (T1 bis T6), die jeweils eine Primärseite und eine Sekundärseite aufweisen, wobei n eine gerade Zahl ist;
- wobei die Sekundärseiten der n Transformatoren (T1 bis T6) in Reihe zwischen den ersten und den zweiten Ausgangsanschluss gekoppelt sind, wobei die Transformatoren (T1 bis T6), i=1 bis n, ausgehend vom ersten Ausgangsanschluss (HV1) zum zweiten Ausgangsanschluss (HV2) beginnend mit 1 fortlaufend bis n durchnummeriert sind;
- wobei jede Primärseite einen ersten und einen zweiten Anschluss aufweist, wobei der jeweils erste Anschluss mit jeweils einem ersten Potential gekoppelt ist und der jeweils zweite Anschluss über einen elektronischen Schalter (S1; S2; S3) mit jeweils einem zweiten Potential koppelbar ist, wobei im Betrieb der Schaltungsanordnung das erste Potential größer ist als das zweite Potential, und wobei das jeweils erste und das jeweils zweite Potential aus der Eingangsspannung (V) abgeleitet sind;
- wobei jeweils mindestens zwei zweite Anschlüsse zur Bildung einer Kombination derart miteinander gekoppelt sind, dass sie durch denselben elektronischen Schalter (S1; S2; S3) mit einem jeweils gemeinsamen zweiten Potential koppelbar sind;
**dadurch gekennzeichnet,**
**dass** bei zumindest einer Kombination der eine zweite Anschluss zum i-ten Transformator (T1), i=1 bis n/2, und der andere zweite Anschluss zum (i+a)-ten Transformator (T4) gehört, wobei a ungleich 1 ist.

2. Schaltungsanordnung nach Anspruch 1,
**dadurch gekennzeichnet,**
**dass** alle Primärseiten mit Bezug auf die Eingangsspannung (V) parallel geschaltet sind.

3. Schaltungsanordnung nach Anspruch 2,
**dadurch gekennzeichnet,**
**dass** bei allen Kombinationen a ungleich 1 ist, insbesondere a=konst.

4. Schaltungsanordnung nach Anspruch 2,
**dadurch gekennzeichnet,**
**dass** jeweils zwei zweite Anschlüsse zur Bildung einer Kombination gekoppelt sind, wobei die jeweilige Kombination die zweiten Anschlüsse der Transformatoren i und (n-i+1) enthält, wobei i=1 bis n/2.

5. Schaltungsanordnung nach Anspruch 1,
**dadurch gekennzeichnet,**
**dass** die Primärseiten in Reihe geschaltet sind, wobei die jeweils ersten Potentiale einer Kombination j von Transformatoren sich ergeben zu (b-j+1)/b * V, wobei b die Anzahl von Kombinationen darstellt und j=1 bis b.

6. Schaltungsanordnung nach Anspruch 5,
**dadurch gekennzeichnet,**
**dass** sich die jeweils zweiten Potentiale einer Kombination j von Transformatoren ergeben zu (b-j)/b * V, wobei b die Anzahl von Kombinationen darstellt und j=1 bis b.

7. Schaltungsanordnung nach einem der Ansprüche 5 oder 6, **dadurch gekennzeichnet,**
**dass** die Kombinationen j in beliebiger Reihenfolge nummeriert sind.

8. Schaltungsanordnung nach einem der Ansprüche 5 bis 7, **dadurch gekennzeichnet,**
**dass** bei allen Kombinationen a ungleich 1 ist, insbesondere a=konst.

9. Schaltungsanordnung nach einem der Ansprüche 5 bis 7 **dadurch gekennzeichnet,**
**dass** jeweils zwei zweite Anschlüsse zur Bildung einer Kombination gekoppelt sind, wobei die jeweilige Kombination die zweiten Anschlüsse der Transformatoren i und (n-i+1) enthält, wobei i=1 bis n/2.

10. Schaltungsanordnung nach einem der vorhergehenden Ansprüche,
**dadurch gekennzeichnet,**
**dass** jeder elektronische Schalter (S1; S2; S3) als MOSFET-Transistor realisiert ist.

## Claims

1. Circuit arrangement having
- a first and a second input connection for connecting an input voltage (V);
- a first and a second output connection (HV1, HV2) for providing an output voltage (U_{A});
- a number n of transformers (T1 to T6) which respectively have a primary side and a secondary side, wherein n is an even number;
- wherein the secondary sides of the n transformers (T1 to T6) are coupled in series between the first and second output connections, wherein the transformers (T1 to T6), i=1 to n, are consecutively numbered from the first output connection (HV1) to the second output connection (HV2) starting at 1 through to n;
- wherein each primary side has a first and a second connection, wherein the respective first connection is coupled to a respective first potential and the respective second connection can be coupled by means of an electronic switch (S1; S2; S3) to a respective second potential, wherein during operation of the circuit arrangement the first potential is greater than the second potential, and wherein the respective first and the respective second potential are derived from the input voltage (V);
- wherein at least two respective second connections are coupled to one another to form a combination such that they can be coupled by the same electronic switch (S1; S2; S3) to a respective common second potential;
**characterized**
**in that** in at least one combination one second connection belongs to the i-th transformer (T1), i=1 to n/2, and the other second connection belongs to the (i+a)-th transformer (T4), wherein a is not equal to 1.

2. Circuit arrangement according to Claim 1,
**characterized**
**in that** all primary sides are connected in parallel with respect to the input voltage (V).

3. Circuit arrangement according to Claim 2, **characterized**
**in that** in all combinations a is not equal to 1, in particular a=const.

4. Circuit arrangement according to Claim 2,
**characterized**
**in that** two respective second connections are coupled to form a combination, wherein the respective combination contains the second connections of the transformers i and (n-i+1), wherein i=1 to n/2.

5. Circuit arrangement according to Claim 1,
**characterized**
**in that** the primary sides are connected in series, wherein the respective first potentials of a combination j of transformers are obtained as (b-j+1)/b * V, wherein b is the number of combinations and j=1 to b.

6. Circuit arrangement according to Claim 5,
**characterized**
**in that** the respective second potentials of a combination j of transformers are obtained as (b-j)/b * V, wherein b is the number of combinations and j=1 to b.

7. Circuit arrangement according to one of Claims 5 and 6,
**characterized**
**in that** the combinations j are numbered in any order.

8. Circuit arrangement according to one of Claims 5 to 7,
**characterized**
**in that** in all combinations a is not equal to 1, in particular a=const.

9. Circuit arrangement according to one of Claims 5 to 7,
**characterized**
**in that** two respective second connections are coupled to form a combination, wherein the respective combination contains the second connections of the transformers i and (n-i+1), wherein i=1 to n/2.

10. Circuit arrangement according to one of the preceding claims,
**characterized**
**in that** each electronic switch (S1; S2; S3) is in the form of a MOSFET transistor.

## Revendications

1. Montage comprenant
- une première et une deuxième borne d'entrée pour l'application d'une tension ( V ) d'entrée ;
- une première et une deuxième borne ( HV1,HV2 ) de sortie pour disposer d'une tension ( UA ) de sortie ;
- un nombre n de transformateurs ( T1 à T6 ) ayant respectivement un côté primaire et un côté secondaire, n étant un nombre pair ;
- dans lequel les côtés secondaires des n transformateurs ( T1 à T6 ) sont montés en série entre la première et la deuxième borne de sortie, les transformateurs ( T1 à T6 ) i=1 à n étant numérotés en allant de la première borne ( HV1 ) de sortie à la deuxième borne ( HV2 ) de sortie en commençant par 1 et en suivant jusqu'à n ;
- dans lequel chaque côté primaire a une première et une deuxième borne, la première borne respective étant couplée à respectivement un premier potentiel et la deuxième borne respective pouvant être couplée respectivement à un deuxième potentiel par un commutateur ( S1,S2,S3 ) électronique, dans lequel, lorsque le montage fonctionne, le premier potentiel est plus grand que le deuxième potentiel et le respectivement premier et le respectivement deuxième potentiel sont dérivés de la tension ( V ) d'entrée ;
- dans lequel respectivement au moins deux deuxièmes bornes sont couplées entre elles pour la formation d'une combinaison de manière à ce qu'elles puissent être couplées par le même commutateur ( S1,S2,S3 ) électronique à un deuxième potentiel respectivement commun ;
**caractérisé**
**en ce que** pour au moins une combinaison l'une des deuxièmes bornes appartient au ième transformateur ( T1 ), i=1 à n/2, et l'autre deuxième borne au ( i+a ) ième transformateur ( T4 ), a étant différent de 1.

2. Montage suivant la revendication 1, **caractérisé en ce que** tous les côtés primaires sont montés en parallèle en référence à la tension ( V ) d'entrée.

3. Montage suivant la revendication 2, **caractérisé en ce que**, pour toutes les combinaisons, a est différent de 1, notamment a=constante.

4. Montage suivant la revendication 2, **caractérisé en ce que** respectivement deux deuxièmes bornes sont couplées pour la formation d'une combinaison, la combinaison respective comportant les deuxième borne des transformateurs i et ( n-1+i ) avec i=1 à n/2.

5. Montage suivant la revendication 1, **caractérisé en ce que** les côtés primaires sont montés en série, les premiers potentiels respectifs d'une combinaison j de transformateurs s'obtenant par ( b-j+1 )/b*V, b étant le nombre de combinaisons et j=1 à b.

6. Montage suivant la revendication 5, **caractérisé en ce que** les respectivement deuxièmes potentiels d'une combinaison j de transformateurs s'obtient par ( b-j )b*V, b étant le nombre de combinaison et j=1 à b.

7. Montage suivant les revendications 5 ou 6, **caractérisé en ce que** les combinaisons j sont numérotées en une succession quelconque.

8. Montage suivant l'une des revendications 5 à 7, **caractérisé en ce que**, pour toutes les combinaisons, a est différent de 1 , notamment a=constante.

9. Montage suivant l'une des revendications 5 à 7, **caractérisé en ce que** respectivement deux deuxièmes bornes sont couplées pour la formation d'une combinaison, la combinaison respective comportant les deuxièmes bornes des transformateurs i et ( n-i+1 ) avec i=1 à n/2.

10. Montage suivant l'une des revendications précédentes, **caractérisé en ce que** chaque commutateur ( S1,S2,S3 ) électronique est réalisé en transistor MOSFET.
